# EUROPÄISCHE PATENTANMELDUNG

(11) **EP 4 496 442 A1**
(43) Veröffentlichungstag der Anmeldung: **22.01.2025**
(21) Anmeldenummer: 23186252.5
(22) Anmeldetag: 18.07.2023
(51) Int. Cl.: H05K 7/20

(54) **KÜHLANORDNUNG, STEUEREINRICHTUNG UND STEUEREINRICHTUNGSSYSTEM**

(71) Anmelder: Continental Automotive Technologies GmbH, 30175 Hannover (DE); Continental Autonomous Mobility Germany GmbH, 85057 Ingolstadt (DE)
(72) Erfinder: Heise, Andreas, 90411 Nürnberg (DE); Niels, Keller, 90411 Nürnberg (DE); Sandris, Georgios, 90411 Nürnberg (DE); Alves Passaro, Joao Pedro, 90411 Nürnberg (DE); Schmidt-Isenthal, Jonas, 90411 Nürnberg (DE)
(74) Vertreter: Continental Corporation

(57) **Zusammenfassung**

Die vorliegende Erfindung betrifft eine Kühlanordnung, umfassend mindestens eine zu kühlende Komponente, insbesondere angeordnet auf einem Schaltungsträger, eine Dampfkammer (11, 31), die an der zu kühlenden Komponente angeordnet ist, derart, dass diese mit der zu kühlenden Komponente thermisch leitfähig gekoppelt ist, eine Kühlvorrichtung, die an der Dampfkammer (11, 31) angeordnet ist, derart, dass die Kühlvorrichtung mit der Dampfkammer (11, 31) thermisch leitfähig gekoppelt ist, und ein Phasenwechselmaterial (19), das an der Dampfkammer (11, 31) angeordnet ist, derart, dass das Phasenwechselmaterial (19) mit der Dampfkammer (11, 31) thermisch leitfähig gekoppelt ist.

## Beschreibung

Die vorliegende Erfindung betrifft eine neuartige Kühlanordnung, insbesondere für einen Sensor oder eine Steuereinrichtung, sowie einen entsprechenden Sensor bzw. eine entsprechende Steuereinrichtung, welcher/welche eine erfindungsgemäße Kühlanordnung aufweist, und ein Steuereinrichtungssystem bzw. Racksystem, umfassend zumindest eine erfindungsgemäße Kühlanordnung bzw. mindestens eine erfindungsgemäße Steuereinrichtung.

### Technologischer Hintergrund

Moderne Fortbewegungsmittel wie Kraftfahrzeuge, Motorräder oder Fluggeräte werden zunehmend mit Steuergeräten bzw. Steuereinrichtungen ausgestattet. Beispielsweise werden im Bereich von Kraftfahrzeugen gattungsgemäße elektronische Steuergeräte (Electronic Control Unit, ECU) bzw. Steuereinrichtungen zur Ansteuerung von Aktoren (Bremse, Motor, Getriebe und dergleichen) und/oder Sensoren sowie zur Berechnung und Steuerung von Fahr- und Assistenzfunktionen eingesetzt. Beispielsweise sind derartige Steuereinrichtungen dabei Teil von Fahrerassistenzsystemen, welche mit Hilfe von Sensoren bzw. Sensorsystemen die Umgebung erfassen, Verkehrssituationen erkennen und den Fahrer unterstützen, z. B. durch einen Brems- oder Lenkeingriff oder durch die Ausgabe einer optischen oder akustischen Warnung. Als Sensoren bzw. Sensorsysteme zur Umgebungserfassung werden regelmäßig Radarsensoren, Lidarsensoren, Kamerasensoren oder dergleichen eingesetzt. Aus den durch die Sensoren ermittelten Sensordaten können anschließend Rückschlüsse auf die Umgebung gezogen werden, womit z. B. eine Objekt- und/oder Umgebungsklassifizierung bzw. ein Umfeldmodell erstellt werden kann. Ferner ist die Umgebungserfassung nahezu unverzichtbar im Bereich des (teil-) autonomen Fahrens, sodass ein besonderes Interesse an der Fort- und Weiterentwicklung derartiger Systeme besteht.

Ein wichtiger Aspekt bei elektronischen Steuergeräten bzw. Steuereinrichtungen ist die Wärmeabfuhr bzw. Kühlung. Die abzuführende Wärme des elektronischen Steuergerätes kann z. B. durch ein thermisch gut leitendes Gehäuse, z. B. Metallgehäuse, des Steuergerätes nach außen geführt werden. An der Oberfläche oder zumindest an z. B. einer Seite des Gehäuses bzw. Steuereinrichtungsgehäuses besteht bei hoher Verlustleistung nun die Herausforderung, die Wärme möglichst gut abzuleiten, damit die im Gehäuse befindlichen Bauteile vor Überhitzung geschützt werden. Es gibt hierzu verschiedene Formen von Kühlsystemen bzw. Kühlungen, z. B. Luftkühlung ggf. mit Kühlrippen bzw. Kühlnoppen oder einen geschlossenen Kühlmittelkreislauf, der an das Gehäuse des Steuergerätes angeschlossen werden kann und eine Gehäusewandung oder deren Oberfläche mit Kühlmittel überströmt.

Gattungsgemäße elektronische Steuergeräte bzw. Steuereinrichtungen, die zunehmend auch in modernen Fahrzeugen oder in der Luftfahrt genutzt werden, werden immer mehr zu sogenannten High-Performance Computersystemen (HPC) bzw. Hochleistungs-Rechnersystemen, wobei die Systeme in der Regel mit Umgebungstemperaturen oder mit Kühlmitteltemperaturen von z. B. -40 bis 80 °C oder mehr funktionieren müssen. Demgegenüber sind jedoch einige Elektronikbauteile in den Steuereinrichtungen, insbesondere Datenspeicherbausteine, wie z. B. RAM (Random Access Memory) oder Flash-Bausteine bzw. EEPROMs (Electrically Erasable Programmable Read-Only Memory), bezüglich der oberen zulässigen Temperatur oftmals sehr eingeschränkt. Ferner sollen insbesondere durch immer schneller werdende Datentransfergeschwindigkeiten, aber auch durch zu vermeidende Spannungsabfälle oder Schwingneigung, schnelle Datenspeicherbausteine möglichst nahe an den sie steuernden Mikroprozessoren bzw. Hochleistungsprozessoren (insbesondere CPUs, GPUs, Switches, ICs oder dergleichen) platziert werden, da diese Platzierung nahe an den Hochleistungsprozessoren meist erst die benötigten schnellen Schreib- und Lesegeschwindigkeiten bzw. Kommunikationsgeschwindigkeiten ermöglicht. Die Hochleistungsprozessoren erzeugen dabei in der Regel erhebliche Abwärme, welche in üblichen Anwendungen deutlich wärmeempfindlichere Bauteile in der unmittelbaren Umgebung der Hochleistungsprozessoren wesentlich erwärmen können und daher die Wärme abtransportiert werden muss. Mit immer größerer Verlustleistung, insbesondere der Hochleistungsprozessoren, werden Nachbarbauteile somit immer stärker thermisch belastet bzw. die Kühlsysteme müssen immer aufwendiger ausgestaltet werden, um die entstehende Wärme von den Erzeugern und den benachbarten teilweise empfindlicheren Bauteilen abzuleiten.

Zweckmäßigerweise unterliegen derartige elektronische Steuergeräte bzw. Steuereinrichtungen verschiedenen Anforderungen, wobei diese insbesondere für ADAS (Advanced Driver Assistance Systems bzw. Fahrerassistenzsystem) -Funktionen aber auch z. B. für Brems- und Lenkungsfunktionen derart ausgeführt werden müssen, dass bei einem Einfachfehler in einem Steuergerät oder auch der Energieversorgung oder des Kühlsystems zumindest eine Rückfallfunktion weiterhin den Betrieb aufrechterhält bzw. in Betrieb bleibt, bis das Fahrzeug in einen sicheren Zustand überführt ist. Diese Anforderung bedeutet z. B. bei Fahrzeugen mit erweiterten autonomen Fähigkeiten, dass für die wichtigen Funktionen doppelte (redundante) Steuergeräte und auch Stromversorgungen verbaut werden müssten. Hierbei soll oftmals in der Rückfallebene bei einem Einfachfehler nicht mehr die gesamte Funktionalität gewährleistet sein - vielmehr ist es in der Regel ausreichend, wenn die verbleibenden Sensoren, Steuergeräte, Aktuatoren und Energieversorgungen und natürlich auch dazugehörige Datenkommunikationswege mit hinreichender Sicherheit das Fahrzeug noch in einen sicheren Zustand bzw. zu einem möglichst sicheren Standort bringen können, wenn z. B. der Fahrer die Kontrolle über das Fahrzeug nicht übernehmen kann oder es sich um ein autonom fahrendes Fahrzeug handelt. Um ein Fahrzeug nach einem Ausfall in einen sicheren Zustand bringen zu können, sind für die weitaus meisten Fälle z. B. 90 Sekunden oder auch 120 Sekunden ausreichend - Selten werden längere Überbrückungszeiten, wie z. B. bis zu mehr als 15 oder 30 Minuten benötigt. Hierbei ist neben den erwähnten Komponenten auch die Kühlung ein kritischer Aspekt, deren Funktionssicherheit auch während dieser Überbrückungszeiten gewährleistet sein sollte.

Gattungsgemäße Steuergeräte werden dabei meist derart ausgelegt, dass Komponenten bei höchster Umgebungstemperatur, höchster Verlustleistung und höchster Kühlmitteltemperatur bei gleichzeitig geringstem Kühlmittelfluss noch (volle) Funktionalität zeigen müssen. Dieses führt dazu das Steuergeräte bei einem Ausfall der Kühlung oft bereits nach wenigen Sekunden (z. B. 3 bis 6 Sekunden) wegen zu hohen Temperaturen bzw. Übertemperatur an einzelnen Bauteilen abschalten müssen. Darüber hinaus sind moderne Steuergeräte für Fahrzeuge üblicherweise derart ausgelegt, dass die volle Funktionsfähigkeit im definierten Temperaturbereich und auch im definierten Spannungsbereiche gegeben sein muss. Bei voll- oder auch teilweise automatisiert fahrenden Fahrzeugen gibt es beispielsweise Situationen, in welchen der automatisierte Fahrbetrieb nicht ermöglicht wird, oder in denen das System den automatisierten Fahrbetrieb mit Vorankündigungszeit einstellen muss, z. B. wenn das Fahrzeug bei fehlender Übernahme durch den Fahrer automatisiert in einen sicheren Zustand gebracht werden muss. Werden beispielsweise Nebel oder Glatteis oder bestimmte Fahrzeugeinschränkungen / Defekte erkannt, so verweigert ein Fahrzeug z. B. den Eintritt in den automatisierten Fahrbetrieb. Auch ein unzureichender Ladezustand oder Treibstoffvorrat kann z. B. den Eintritt in den automatisierten Fahrbetrieb unterbinden, da mit einem Liegenbleiben des Fahrzeuges zu rechnen wäre.

Werden mehrere Steuergeräte bzw. Steuereinrichtungen beispielsweise durch einen gemeinsamen Luftstrom oder einen Flüssigkeitskreislauf gemeinsam gekühlt (z. B. auch in einem sogenannten Racksystem), so kann durch Ausfall des notwendigen Fluidstromes (Kühlmittelstrom, Luftstrom oder dergleichen) der Ausfall gleich mehrerer Steuergeräte erfolgen. Hierbei besteht die Problematik, dass ein zweiter, wirklich unabhängiger (Flüssigkeits-) kühlkreislauf oftmals wegen des erheblichen Aufwands nicht realisierbar erscheint, wohingegen eine einfache Luftkühlung bei Steuergeräten mit erhöhter Verlustleistung oft nicht die erforderliche Leistung erzeugen kann, da hierzu zum einen eine starke und unerwünschte Geräuschentwicklung auftreten kann und zum anderen viel Fluidvolumen bzw. Luftvolumen benötigt wird. Infolgedessen besteht ein gesteigertes Interesse an Lösungen, die es ermöglichen, im Bereich von High-Performance-Computern (HPC) und anderen Geräten bei überschaubaren Zeiträumen im kleinen meist einstelligen Minutenbereich oder sogar zweistelligen Minutenbereich auf z. B. ein zweites komplettes Kühlsystem zu verzichten.

### Druckschriftlicher Stand der Technik

Aus der DE 10 2020 104 614 A1 ist eine Einrichtung für ein Kraftfahrzeug bekannt, mit wenigstens einer zumindest einen Halbleiter aufweisenden zu kühlenden Komponente, und mit einer Kühleinrichtung, mittels welcher die zu kühlende Komponente zumindest teilweise gekühlt werden kann und von der Komponente bereitgestellte Wärme an eine Wärmesenke abführbar ist. Die Kühleinrichtung ist dabei als gravitationsbasierte Dampfkammer ausgebildet, durch die unter Nutzung des Zweiphasen-Thermosiphon-Effekts die Wärme zu der Wärmesenke abführbar ist. Die gravitationsbasierte Dampfkammer weist hierzu ein Bodenelement auf, welches eine der Komponente zugewandte erste Seite und eine der ersten Seite und der Komponente abgewandte und einem Innenraum der Dampfkammer zugewandte zweite Seite aufweist, womit eine besonders vorteilhafte Kühlung realisiert werden kann. Ferner sind zwischen Dampfkammer und zu kühlender Komponente ggf. eine Keramikschicht, eine Kontaktierung, eine Sinterschicht und mehrere Lotschichten vorgesehen.

### Aufgabe der vorliegenden Erfindung

Die Aufgabe der vorliegenden Erfindung besteht nunmehr darin, eine gattungsgemäße Kühlanordnung anzugeben, womit ein guter Wärmeabtrag von einer zu kühlenden Komponente (bzw. den zu kühlenden Baugruppenkomponenten) auch während einer Überbrückungszeit erreicht wird und die sich aus dem Stand der Technik ergebenden Nachteile in einfacher und kostengünstiger Weise überwunden werden.

### Lösung der Aufgabe

Die vorstehende Aufgabe wird durch die gesamte Lehre des Anspruchs 1 sowie der nebengeordneten Ansprüche gelöst. Zweckmäßige Ausgestaltungen der Erfindung sind in den Unteransprüchen beansprucht.

Die erfindungsgemäße Kühlanordnung umfasst mindestens eine zu kühlende Komponente, die insbesondere auf einem Schaltungsträger (z. B. Leiterplatte, Platine, Substrat oder dergleichen) angeordnet ist, eine Dampfkammer, die auf einer Seite an der zu kühlenden Komponente angeordnet ist, derart, dass diese mit der zu kühlenden Komponente thermisch leitfähig gekoppelt ist (z. B. kann diese auch über ein thermisches Interface Material TIM oder ein Lot oder einen Kleber an der zu kühlenden Komponente angeordnet und thermisch leitfähig gekoppelt sein), und ein äußerlich an der Dampfkammer angebrachtes Phasenwechselmaterial bzw. PCM (Phase Change Material), so dass das Phasenwechselmaterial mit der Dampfkammer thermisch leitfähig gekoppelt ist. Ferner ist eine Kühlvorrichtung vorgesehen, die z. B. an einer der zu kühlenden Komponente gegenüberliegenden Seite der Dampfkammer angeordnet ist, so dass die Kühlvorrichtung mit der Dampfkammer thermisch leitfähig gekoppelt ist. Dadurch kann die von der ersten thermischen Komponente aufgenommene Wärme, die durch die zu kühlende Komponente erzeugt wurde, abgeführt werden.

Die vorliegende Erfindung zeigt unter anderem eine vorteilhafte Ausgestaltung einer Kühlanordnung z. B. für Steuergeräte insbesondere auch Hochleistungsrechner, sogenannte High-Performance Computer (HPC), bzw. High-Performance-Steuergeräte, ohne größere Veränderungen am Steuergeräteaufbau vornehmen zu müssen, womit zum einen die allgemeine Kühlwirkung verbessert wird und zum anderen die hinreichende Kühlung z. B. auch für einen kurzen Überbrückungszeitraum noch sichergestellt werden kann. Die Verlängerung der Überbrückungszeit kann zusätzlich in einem gewissen Rahmen auch durch das technische Design oder zusätzliche weitere Maßnahmen, z. B. auf Softwareebene, beeinflusst werden.

Zweckmäßigerweise kann die Dampfkammer bzw. "Vaporchamber" z. B. aus Metall, insbesondere Kupfer und/oder Aluminium und/oder Legierungen daraus, gefertigt sein. Gemäß einer besonders bevorzugten Ausgestaltung kann die Dampfkammer auch aus einem Aluminium-Kupfer Verbundmaterial bestehen und z. B. als sogenanntes Strangpressteil oder Fließpressteil gefertigt sein. Eine derartige Ausgestaltung kann besonders gut geeignet sein, da das Aluminium besonders flexibel einsetzbar ist (z. B. kompatibel mit den Aluminiumbauteilen, die in Kühlwasserkreisen eingesetzt werden) und das Kupfer hervorragende Wärmeleitungseigenschaften aufweist, so dass die Vorteile beider Materialien vereint werden können. Bevorzugt werden hier Aluminium bzw. Aluminiumlegierungen verwendet. Je nach Metall und eingestelltem Unterdruck können als Flüssigkeiten im Inneren der Dampfkammer Wasser, Aceton aber auch Kältemittel, wie sie in Klimaanlagen verwendet werden und andere Medien Anwendung finden. Die Dampfkammer umfasst dabei ein inneres Volumen aus innenliegenden Kanälen oder Bereichen, in denen z. B. etwas Flüssigkeit bei einem Unterdruck angeordnet wird, die bei den Betriebstemperaturen der zu kühlenden Komponente verdampft, so dass die Wärme abgeführt werden kann, solange Flüssigkeit zum Verdampfen vorhanden ist. In bevorzugter Weise wird im Rahmen der Erfindung eine Dampfkammer verwendet, welche vorzugsweise im Inneren eines hermetisch abgeschlossenen Dampfkammergehäuses (inklusive äußerer Verlötung oder Verschweißung) eine Kapillarstruktur aufweist, welche, je nach Einbaulage, neben der Schwerkraft zusätzlich zum Transport bzw. Befördern kondensierter Flüssigkeit beiträgt, insbesondere aufgrund des Kapillareffekts. Der Kapillareffekt kann dabei durch Oberflächenstrukturen oder eingefügte Materialien an der Innenwandung der Dampfkammer ausgeführt sein. Hierdurch gelangt darin befindliches flüssiges Fluid an die wärmsten Stellen des Dampfkammergehäuses, an denen die Flüssigkeit im Betrieb verdampft. Durch diesen Fluidtransport wird ein Kreislauf von Aggregatzustandswechsel (flüssig zu gasförmig zu flüssig usw.) erzeugt und aufrechterhalten. Das Gehäuse derartiger Dampfkammern lässt sich durch einen Deckel und ein Bodenteil realisieren, kann aber auch bevorzugt durch Strangpressprofile oder Fließpressteile als einstückiges Halbzeug bzw. in einem Stück hergestellt werden.

Vorzugsweise ist als Kühlvorrichtung eine Fluidkühlung, insbesondere eine Luftkühlung oder Flüssigkeitskühlung, vorgesehen. Beispielsweise zeichnet sich hierbei eine Flüssigkühlung dadurch aus, dass diese besonders effektiv Wärme abführen kann, wodurch die Kühlleistung noch zusätzlich verbessert wird. Als Kühlmedium kann beispielsweise Wasser-Glykol, Wasser, Glykol oder eine andere Kühlmittelflüssigkeit verwendet werden. Darüber hinaus kann als kühlendes Fluid auch gasförmiges Fluid vorgesehen sein, wie zum Beispiel Luft, Stickstoff oder Kohlenstoffdioxid.

Zweckmäßigerweise kann als Kühlvorrichtung ein elastischer Balg oder ein Kühlpad vorgesehen sein, der/das zumindest teilweise aus flexiblem Material gefertigt ist, und derart angeordnet wird, dass sich der elastische Balg oder das Kühlpad an die Dampfkammer und ggf. auch an Gehäuseteile der Steuereinrichtung anschmiegt, wobei als flexibles Material vorzugsweise Metallfolie, insbesondere Aluminiumfolie oder Kupferfolie, und/oder Kunststofffolie und/oder ein Laminat und/oder eine Verbundfolie, welche insbesondere eine Metallfolie und eine Kunststofffolie umfasst, vorgesehen ist.

Ferner kann bei der erfindungsgemäßen Kühlanordnung ein Gehäuse vorgesehen sein, welches vorzugsweise aus Metall oder Kunststoff gefertigt ist. Bei dem Gehäuse kann es sich z. B. um ein Steuereinrichtungsgehäuse oder ein Sensorgehäuse zur Umfeld- bzw. Umgebungserfassung handeln, in welchem die zu kühlende Komponente beispielsweise auf einem Schaltungsträger (z. B. Platine, Substrat oder Leiterplatte) angeordnet ist.

Gemäß einer vorteilhaften Ausgestaltung der vorliegenden Erfindung kann die Dampfkammer Teil des Gehäuses, insbesondere des Steuereinrichtungsgehäuses oder des Sensorgehäuses, sein. In praktischer Weise kann die Dampfkammer hierbei integraler Bestandteil des Gehäuses sein, z. B. kann diese eine Seitenwand des Gehäuses, ein Deckel, ein Inlay, ein Boden oder dergleichen sein. Die Dampfkammer ist hierzu vorzugsweise plattenförmig ausgestaltet und kann vorzugsweise als Strangpressprofil oder Fließpressteil und/oder aus Stanzteil(en) hergestellt bzw. gefertigt sein.

Alternativ oder zusätzlich kann auch die Kühlvorrichtung zumindest teilweise integraler Bestandteil des Gehäuses sein. Beispielsweise kann die Kühlvorrichtung, wenn diese als Flüssigkeitskühlung bzw. Fluidkühlung ausgestaltet ist, derart in das Gehäuse integriert werden, dass die Fluidkanäle bzw. Kühlmittelkanäle in das Gehäuse der Steuereinrichtung bzw. des Sensors integriert werden.

In vorteilhafter Weise kann die Dampfkammer eine Struktur, insbesondere Rippen und/oder Noppen und/oder Pins und/oder Finnen, aufweisen, an denen das Phasenwechselmaterial angeordnet wird. Zusätzlich können natürlich auch Kühlstrukturen, wie Kühlrippen und/oder Kühlnoppen und/oder Kühlpins und/oder Kühlfinnen vorgesehen sein, die sozusagen Teil der Kühlvorrichtung (z. B. Luftkühlung) sind und somit als integraler Bestandteil sogleich an der Dampfkammer angeordnet werden, so dass Dampfkammer und Kühlvorrichtung auch einstückig vorliegen können bzw. als ein Bauteil (z. B. Strangpressteil, Fließpressteil) gefertigt wird. Die Kühlstrukturen dienen beispielsweise dazu, von einem Kühlmedium (z. B. Luft, Wasser, Kühlmittel oder dergleichen) umströmt zu werden, sodass dadurch Wärme abgeführt werden kann. Dadurch kann eine effektive Kühlung in besonders praktischer Weise umgesetzt werden.

Als Phasenwechselmaterial oder PCM (Phase Change Material) wird im Sinne der Erfindung ein spezieller Typ von Wärmespeicher verstanden, der einen Großteil der ihm zugeführten thermischen Energie in Form von Umwandlungsenthalpie, auch latente oder verborgene Wärme genannt, für einen Phasenwechsel von fest zu flüssig aufnimmt und speichert. Solange die Phasenumwandlung dabei nicht ganz abgeschlossen ist, steigt die Temperatur des Stoffes (und damit die Temperatur der thermisch angebundenen Dampfkammer bzw. der zu kühlenden Komponente) trotz Wärmezufuhr nicht weiter an. Dadurch können in einem bestimmten Temperaturbereich rund um den Phasenwechsel sehr große Wärmemengen gespeichert bzw. aufgenommen werden. Die Auswahl des jeweiligen Phasenwechselmaterials (PCM) erfolgt hierbei insbesondere auch anhand des benötigten Schmelzpunktes, so dass eine anwendungsspezifische Auswahl erfolgen kann. Beispielsweise können spezielle Salzhydrate oder Paraffine als Speichermedium eingesetzt werden. Bevorzugt soll das eingesetzte Material viel Energie (Schmelzenthalpie) aufnehmen und dabei wenig Platz benötigen, so dass ausreichend "Wärme aufgenommen" werden kann.

Das verwendete bzw. eingesetzte Phasenwechselmaterial umfasst vorzugsweise ein Verdickungsmittel, insbesondere einen Fließverhinderer, z. B. in Form von Blockpolymeren, durch das die PCM-Mischung am Verflüssigen im Betriebstemperaturbereich gehindert wird. Zudem behält das eingebrachte Verdickungsmittel aber auch die Fließfähigkeit bei höheren Temperaturen, wodurch auch die gesamte PCM-Mischung die Fließfähigkeit bei höheren Temperaturen behält, so dass der Herstellungsprozess in besonderem Maße vereinfacht wird. Ferner ist vorgesehen, dass die PCM-Mischung möglichst nur so viel Verdickungsmittel enthält, dass diese im oberen Betriebstemperaturbereich nicht mehr steif, sondern "puddingartig" oder "cremeartig" oder "pastös" wird, aber im Betriebszustand ausreichend fest ist, so dass dieses nicht "wegfließt". Weiterhin kann die PCM-Mischung Material beinhalten, wie z. B. Graphit oder Metallfasern oder Partikel oder ähnliches, welches die thermische Leitfähigkeit erhöht und welches die thermische Anbindung an Rippen, Finnen oder Pins an die Dampfkammer verbessern bzw. ermöglichen kann.

Ferner kann das Phasenwechselmaterial an der Dampfkammer angeordnet werden, indem ein Gewirk, insbesondere Metallgewirk umfassend ein Kupfer- und/oder Aluminiumgeflecht, auf/an der Dampfkammer angeordnet und/oder befestigt ist, welches mit Phasenwechselmaterial verfüllt wird, insbesondere knäuelartig, indem z. B. das durch das Kupfer- oder Aluminiumgeflecht entstandene Gewirk Zwischenräume aufweist, in denen das Phasenwechselmaterial eingebracht wird, sodass die Zwischenräume mit Phasenwechselmaterial verfüllt sind.

Alternativ oder zusätzlich können die eingesetzten Phasenwechselmaterialien vorzugsweise derart angeordnet oder ausgesucht werden, dass durch dessen Beschaffenheit sichergestellt wird, dass das Phasenwechselmaterial infolge eines Einflusses von Wärme, Vibration, Alterung und dergleichen vorzugsweise über dessen Lebensdauer hinaus nicht entweichen kann und auch keine Geruchsbelästigungen z. B. im Fahrzeuginnenraum verursachen kann.

Zweckmäßigerweise kann das Phasenwechselmaterial hierzu auch eine Hülle (z. B. Gefäß, Reservoir oder Beschichtung dergleichen) aufweisen, in dem das Phasenwechselmaterial oder auch das als Gewirk bzw. Knäuel ausgestaltete Phasenwechselmaterial angeordnet ist und welches an der ersten thermischen Komponente angeordnet ist. Bei der Hülle kann es sich beispielsweise um einen Kunststoff Beutel, ein Kunststoffgehäuse, ein Polymergebinde oder dergleichen handeln. Die Anforderung an die Hülle sind hierbei im Wesentlichen eine hohe Dichtheit, sodass das Phasenwechselmaterial über die Lebensdauer des Bauteils hinaus nicht aus der Hülle austreten kann und nahezu Geruchsneutralität gewährleistet ist, wobei zum einen das Material der Hülle keine giftigen und/oder olfaktorisch belästigenden Stoffe absondern sollte, als auch dass keine giftigen und/oder olfaktorisch belästigenden Stoffe des Inhalts (PCM) nach außen dringen können. Beispielsweise kann dadurch verhindert werden, dass eine Geruchsbelästigung der Insassen eines Fahrzeuges durch ein entsprechendes Steuergerät, welches sich nahe am Fahrgastraum des Fahrzeuges befinden kann, verursacht wird.

Gemäß einer bevorzugten Ausgestaltung der Erfindung kann zwischen der Dampfkammer und der zu kühlenden Komponente ein TIM bzw. eine TIM-Schicht angeordnet sein. Durch die erfindungsgemäße Anordnung kann die Dicke der TIM-Schicht bzw. Schichten und/oder die Anzahl der TIM-Schichten reduziert werden, dahingehend, dass der Wärmeübertrag von der zu kühlenden Komponente auf die Dampfkammer in besonderem Maße verbessert wird. Ferner muss durch diese Kühlanordnung die TIM-Schicht nur noch sehr dünn aufgetragen werden, bzw. kann sogar in Gänze weggelassen werden.

Zweckmäßigerweise kann die Kühlvorrichtung und/oder das Phasenwechselmaterial auch derart an der Dampfkammer angeordnet sein, dass die Kühlstrukturen (z. B. Kühlrippen und/oder Kühlnoppen und/oder Kühlpins und/oder Kühlfinnen) der Dampfkammer in die Kühlvorrichtung und/oder das Phasenwechselmaterial eingreifen oder hineinragen. In praktischer Weise kann die Kühlvorrichtung bzw. das Phasenwechselmaterial hierbei eine gewisse Flexibilität aufweisen, sodass sich dieses an die kühlenden Strukturen "anschmiegt", d. h. das Außenmaterial ist flexibel und wird durch den entstehenden Druck der Füllung bzw. des Filmmaterials an die Struktur, insbesondere ohne nennenswerten Zwischenraum, gedrückt bzw. angeformt.

Gemäß einer besonderen Ausgestaltung der vorliegenden Erfindung kann die Dampfkammer gebogen sein, sodass diese eine, insbesondere geschwungene oder U-förmig oder L-förmig gebogene, Umformung aufweist, welche beispielsweise aus der Dimension des Gehäuses herausragt (d. h. ein Teil der Dampfkammer kann sich zumindest teilweise außerhalb des Gehäuses bzw. Steuereinrichtungsgehäuses befinden, um dadurch eine verbesserte Kühlleistung zu bewirken bzw. mehr Phasenwechselmaterial an der Dampfkammer unterbringen zu können. Ferner kann dabei zumindest Phasenwechselmaterial in größerem Volumen angeordnet sein, wobei in dem Bereich Strukturen (z. B. Rippen und/oder Noppen und/oder Pins und/oder Finnen und/oder dergleichen) vorkommen können, die in das Phasenwechselmaterial eingreifen bzw. mit diesem ineinandergreifend angeordnet sind.

Ferner können die Dampfkammer und die Kühlvorrichtung einstückig ausgestaltet sein, so dass ein Bauteil beide Komponenten umfasst und somit zwei (Kühl-) Eigenschaften aufweist. Beispielsweise kann die Fluidkühlung an der Dampfkammer angebracht sein bzw. diese können als ein Stück gefertigt sein. Darüber hinaus könnten zusätzliche Kanäle an der Dampfkammer angebracht sein, z. B. indem die Dampfkammer als Strangpressprofil gefertigt wird. An den zusätzlichen Kanälen könnte dann beispielsweise die Kühlwasserversorgung des Fahrzeuges angeschlossen werden, welche dann die Dampfkammerwandung unmittelbar kühlt. Die thermische Kopplung kann dadurch noch zusätzlich erhöht werden. Darüber hinaus können natürlich, wie bereits beschrieben, Kühlstrukturen an der Dampfkammer angeordnet sein, die Teil einer Luftkühlung sind und beispielsweise mit einem Luftstrom umströmt werden.

Ferner beansprucht die vorliegende Erfindung eine Steuereinrichtung oder einen Sensor (zum Beispiel ein Radarsensor, Lidarsensor, Kamerasensor, Ultraschallsensor oder dergleichen), die/der eine erfindungsgemäße Kühlanordnung umfasst.

Darüber hinaus umfasst die vorliegende Erfindung ein Steuereinrichtungssystem bzw. auch Racksystem, welches mindestens eine erfindungsgemäße Kühlanordnung oder mindestens eine erfindungsgemäße Steuereinrichtung umfasst. Hierbei sind mindestens zwei Steuereinrichtungen vorgesehen, aufweisend jeweils mindestens eine zu kühlende Komponente und eine Dampfkammer, die an der zu kühlenden Komponente angeordnet ist, derart, dass diese mit der zu kühlenden Komponente thermisch leitfähig gekoppelt ist. Ferner ist eine Kühlvorrichtung vorgesehen, die an den Dampfkammern der Steuereinrichtungen angeordnet ist, derart, dass die Kühlvorrichtung mit den Dampfkammern der zumindest zwei Steuereinrichtungen thermisch leitfähig gekoppelt ist. Dadurch wird erreicht, dass z. B. nur ein Fluidkühlsystem oder nur ein Kühlpad benötigt wird, um Wärme mehrerer Dampfkammern aufzunehmen bzw. abzuführen.

Gemäß einer vorteilhaften Ausgestaltung des erfindungsgemäßen Steuereinrichtungssystems können die Steuereinrichtungen jeweils ein Steuereinrichtungsgehäuse aufweisen, wobei die Steuereinrichtungsgehäuse miteinander mechanisch verbunden sind, insbesondere verklebt, verschweißt, verschraubt, vernietet oder dergleichen.

Zweckmäßigerweise kann es sich bei der zu kühlenden Komponente um einen Mikrocontroller und/oder einen Prozessor und/oder einen Chip und/oder einen Integrierten Schaltkreis (IC) und/oder ein System-on-Chip (SoC) und/oder ein Halbleiterbauteil und/oder einen Schaltungsträger und/oder eine Batterie und/oder andere elektronische Bauteilkomponenten oder Kompositionen daraus handeln, die beispielsweise auf mindestens einem Schaltungsträger bzw. Leiterplatte und/oder Platine (PCB) und/oder Substrat angeordnet ist.

### Beschreibung der Erfindung anhand von Ausführungsbeispielen

Im Folgenden wird die Erfindung anhand von zweckmäßigen Ausführungsbeispielen näher erläutert. Es zeigen:
Fig. 1: eine vereinfachte schematische Darstellung einer Ausgestaltung eines Fahrzeuges mit einer erfindungsgemäßen Steuereinrichtung;
Fig. 2: eine vereinfachte Schnittdarstellung einer Ausgestaltung einer erfindungsgemäßen Steuereinrichtung;
Fig. 3A: eine vereinfachte schematische Schnittdarstellung einer Ausgestaltung von an der Dampfkammer angeordneten Phasenwechselmaterial;
Fig. 3B: eine vereinfachte schematische Schnittdarstellung einer Ausgestaltung von knäuelartig angeordneten Phasenwechselmaterial;
Fig. 3C: eine vereinfachte schematische Schnittdarstellung einer Ausgestaltung von Phasenwechselmaterial mit einer Hülle;
Fig. 4: eine vereinfachte Schnittdarstellung einer weiteren Ausgestaltung einer erfindungsgemäßen Steuereinrichtung mit zwei an der Dampfkammer gegenüberliegend angeordneten Phasenwechselmaterialvolumen;
Fig. 5: eine vereinfachte Schnittdarstellung einer weiteren Ausgestaltung der erfindungsgemäßen Steuereinrichtung mit verlängerter Dampfkammer;
Fig. 6A-6J: vereinfachte Darstellungen von Ausgestaltungen einer Dampfkammer einer erfindungsgemäßen Kühlanordnung;
Fig. 7: eine vereinfachte Schnittdarstellung einer Ausgestaltung eines erfindungsgemäßen Steuereinrichtungssystems mit zwei Steuereinrichtungen;
Fig. 8: eine vereinfachte Schnittdarstellung einer weiteren Ausgestaltung eines erfindungsgemäßen Steuereinrichtungssystems mit zwei Steuereinrichtungen;
Fig. 9: eine vereinfachte Schnittdarstellung einer weiteren Ausgestaltung eines erfindungsgemäßen Steuereinrichtungssystems mit zwei Steuereinrichtungen;
Fig. 10A: eine vereinfachte Darstellung einer Ausgestaltung einer erfindungsgemäßen Steuereinrichtung mit einer Dampfkammer, die Kühlrippen und Rippen umfasst und an der Phasenwechselmaterial angeordnet ist;
Fig. 10B: eine vereinfachte Darstellung einer Ausgestaltung einer Dampfkammer für eine Steuereinrichtung nach Fig. 10A;
Fig. 10C: eine vereinfachte Darstellung einer Ausgestaltung einer Dampfkammer für eine Steuereinrichtung nach Fig. 10A, umfassend Kühlrippen und Rippen, wobei das Phasenwechselmaterial und die Rippen ineinandergreifend angeordnet sind, sowie
Fig. 11: eine Darstellung einer Ausgestaltung des Zusammenhangs zwischen der Temperatur an der zu kühlenden Komponente und dem Aufschmelzen des Phasenwechselmaterials nach Eintreten eines Fehlerereignisses.

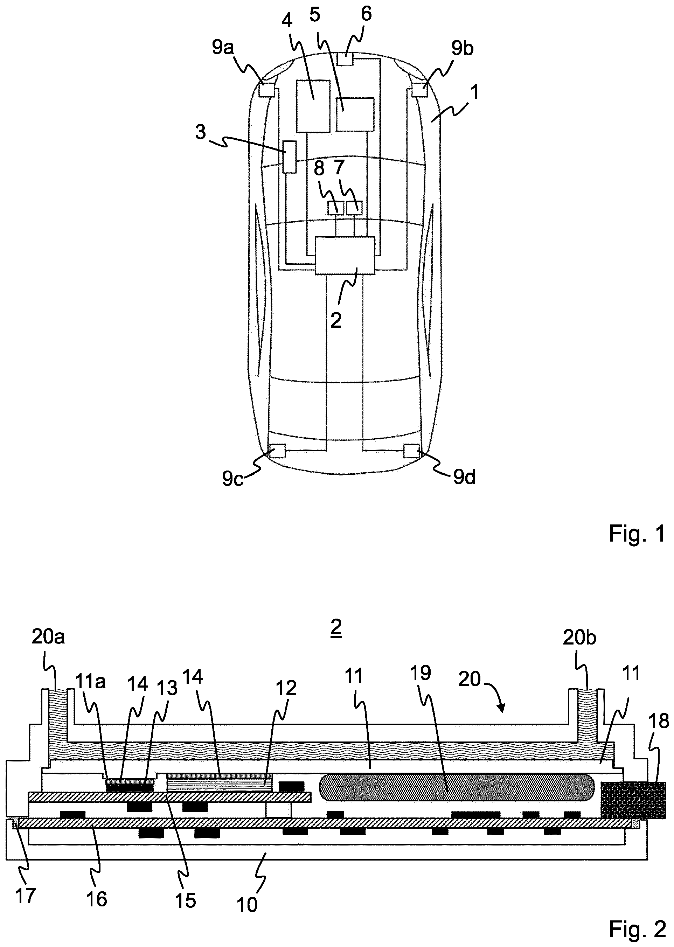

Bezugsziffer 1 in Fig. 1 bezeichnet ein Fahrzeug mit verschiedenen Aktoren (Lenkung 3, Motor 4, Bremse 5), welches eine erfindungsgemäße Steuereinrichtung 2 (ECU, Electronic Control Unit oder ADCU, Assisted and Automated Driving Control Unit) aufweist, durch die eine (teil-) automatisierte Steuerung des Fahrzeuges 1 erfolgen kann, z. B. indem die Steuereinrichtung 2 auf die Aktoren des Fahrzeuges 1 zugreifen kann. Zudem weist die Steuereinrichtung 2 eine Speichereinheit auf, um z. B. einen Algorithmus, Steueranweisungen oder Muster zu speichern. Ferner weist das Fahrzeug 1 Sensoren zur Umfelderfassung auf: einen Radarsensor 6, einen Lidarsensor 7 und eine Frontkamera 8 sowie mehrere Ultraschallsensoren 9a-9d, deren Sensordaten zur Umfeld- und Objekterkennung genutzt werden, sodass verschiedene Assistenzfunktionen, wie z. B. Notbremsassistent (EBA, Electronic Brake Assist), Abstandsfolgeregelung (ACC, Adaptive Cruise Control), Spurhalteregelung bzw. ein Spurhalteassistent (LKA, Lane Keep Assist), Parkassistent oder dergleichen, realisiert werden können. Die Ausführung der Assistenzfunktionen erfolgt dabei z. B. über die Steuereinrichtung 2 bzw. dem dort hinterlegten Algorithmus. Die erfindungsgemäße Kühlanordnung kann hierbei prinzipiell in jedem der Sensoren oder Steuergeräte oder der Steuereinrichtung 2 umgesetzt werden.

Ein wichtiger Aspekt bei gattungsgemäßen Kühlanordnungen ist, dass etwaige thermische Toleranzbereiche und Maximalgrenzwerte der zu kühlenden Komponenten stets eingehalten werden sollten, um einen Schaden am jeweiligen Bauteil zu vermeiden. Beispielsweise sollten die Bauteile bei Eintritt in die automatisierte Fahrfunktion einen thermischen Abstand von einigen Grad Celsius bzw. Kelvin zur Abschalttemperatur aufweisen, z. B. 5 Kelvin oder 10 Kelvin oder 15 Kelvin oder 20 Kelvin. Dieses kann dadurch erreicht werden, dass automatisiertes Fahren nur dann eingeleitet wird, wenn das Kühlmedium des Kühlsystems sich nicht am oder nicht nahe am oberen Grenzwert (=Höchsttemperatur bzw. Maximaltemperatur des Systems) befindet, bzw. die Bauteile (was oftmals jedoch nicht möglich ist) noch einige Kelvin Reserven bis zur Maximaltemperatur aufweisen. Die Auslegung auf eine tatsächlich geringere Starttemperatur ist unproblematisch, da diese ohnehin selten vorkommt, da bei hoher Umgebungstemperatur und gleichzeitig hoher bzw. extremer Belastung des Fahrzeugs durch herausfordernden Fahrbetrieb in der Regel kein autonomer Betrieb gestartet wird bzw. Fahrzeuge im autonomen Betrieb in der Regel nicht (häufig) an der Leistungsgrenze fahren. Der Abstand von einigen Kelvin verlängert die Abschaltzeit in der Regel jedoch nur sehr wenig, da der Gradient des Temperaturanstiegs sehr hoch ist. Zudem erhöhen die Pufferkapazitäten aber auch die thermisch niederohmige Anbindung von Kühlkörpern oder "Heatspreadern" oder Kühlrippen oder Fluidkühlern an viel Abwärme erzeugenden Bauteilen die Zeit bis zum Überschreiten der Maximaltemperatur oftmals nur um Sekunden. Die Erfindung schlägt daher neben der bisher beschriebenen Vorgehensweise zu einer weiteren Verlängerung der Nachlaufzeit nach Kühlungsausfall auch das Heruntersetzen der Verlustleistung der betroffenen Wärmeerzeugenden Bauteile (z. B. Abschalten oder Heruntertakten) vor.

In Fig. 2 ist eine erfindungsgemäßen Steuereinrichtung 2 mit Steuereinrichtungsgehäuse 10 gezeigt, wobei die Anbindung thermisch kritischer Komponenten bzw. zu kühlender Komponenten mittels einer sogenannten "Vaporchamber" bzw. Dampfkammer 11 vorgesehen ist, welche bevorzugt durch eine oder mehrere Erhebungen bzw. Vorsprünge 11a nahe an die zu kühlenden, thermisch kritischen Komponenten angeordnet sind. Als zu kühlende Komponenten sind in Fig. 2 beispielhaft ein Prozessor 12 sowie ein IC-Baustein 13 vorgesehen. Zwischen Dampfkammer 11 und Prozessor 12 bzw. IC-Baustein 13 ist jeweils eine Schicht TIM 14 (Thermal Interface Material) angeordnet, das der Übersichtlichkeit halber in den Figuren jedoch sehr viel dicker dargestellt ist, als dieses real vorgesehen wird. Durch das TIM 14 können die thermisch am meisten Verlustleistung abgebenden Komponenten möglichst direkt berührend angebunden bzw. kontaktiert werden. Andere zu kühlende Bauteile können zudem entweder direkt oder mittels thermisch leitfähiger Materialien, z. B. Aluminium- oder Kupferbauteile (z. B. "Kupferklötzchen" oder dergleichen), mittels zusätzlichem TIM angebunden werden. Die Dampfkammer 11 ist hierbei mit dem Steuereinrichtungsgehäuse 10 verbunden bzw. diese ist als Seitenwand oder Deckel oder Inlay des Steuereinrichtungsgehäuses 10 ausgestaltet, und somit integraler Bestandteil des hier sonst zweiteilig ausgeführten Steuereinrichtungsgehäuses 10. Die Dampfkammer 11 kann hierbei mit dem Gehäuse verschraubt, verklebt, vernietet oder dergleichen sein. Ferner befinden sich die zu kühlenden Komponenten auf einer Leiterplatte 15, die innerhalb des Steuereinrichtungsgehäuses 10 angeordnet bzw. befestigt ist. Darüber hinaus können auch weitere Leiterplatten 16 im Steuereinrichtungsgehäuse 10 angeordnet sein. In Fig. 2 sind die Leiterplatten 15, 16 als sogenanntes SOM (System on Module) umfassend eine Leiterplatte 16 und ein Zusatzboard (Leiterplatte 15) ausgestaltet. Die Leiterplatten 15,16 können hierbei z. B. zwischen zwei Teilen des Steuereinrichtungsgehäuses 10 geklemmt und zusätzlich durch einen Dichtkleber 17 befestigt sein, wie bei Leiterplatte 16 dargestellt. Die Leiterplatte 16 weist zudem einen Anschlussstecker 18 auf, der zum Anschluss der Leiterplatte 16 bzw. der Steuereinrichtung 2 dient. Beide Leiterplatten sind zudem über einen Verbindungsstecker miteinander verbunden (als Rechteck zwischen den Leiterplatten dargestellt). Zudem ist eine Fluidkühlung 20 vorgesehen, die über Eingang 20a und Ausgang 20b an einem Fluidkreislauf bzw. Kühlmittelkreislauf angeschlossen ist, um Wärme von der Dampfkammer 11 abzuführen. Die Flüssigkeitskühlung 20 ist hierbei integraler Bestandteil des Steuereinrichtungsgehäuses 10 - sozusagen als "Inlay" im Steuereinrichtungsgehäuses 10. Das Steuereinrichtungsgehäuse 10 ist hierbei als wasserführendes Gehäuse aus Aluminium ausgestaltet.

Die Dampfkammer 11 ist in der Regel derart ausgeführt, dass an der den angebundenen Bauteilen gegenüberliegenden Fläche im Normalbetrieb die Wärme z. B. über ein Fluidkühlsystem oder durch ein flexibles fluiddurchströmtes Kühlpad abgeführt wird. Die Dampfkammerseite, an welcher die zu kühlenden Bauteile (z. B. über thermische Leitpaste bzw. TIM) angebunden sind, wird vergleichsweise großflächig ausgeführt und es werden bevorzugt erhöhte Abstände zu anderen elektronischen Bauteilen geschaffen. Vorzugsweise kann die Dampfkammer auch über den Schaltungsträger der thermisch sehr kritischen Leiterplatte hinausragen. Bei geeigneter technischer Ausführung kann die Dampfkammer 11 an der Oberfläche eben sein oder mit dem Steuereinrichtungsgehäuse 10 eine Art Stufe bilden, d. h. entweder im Vergleich zum Steuereinrichtungsgehäuse 10 erhöht oder in dieses versenkt sein.

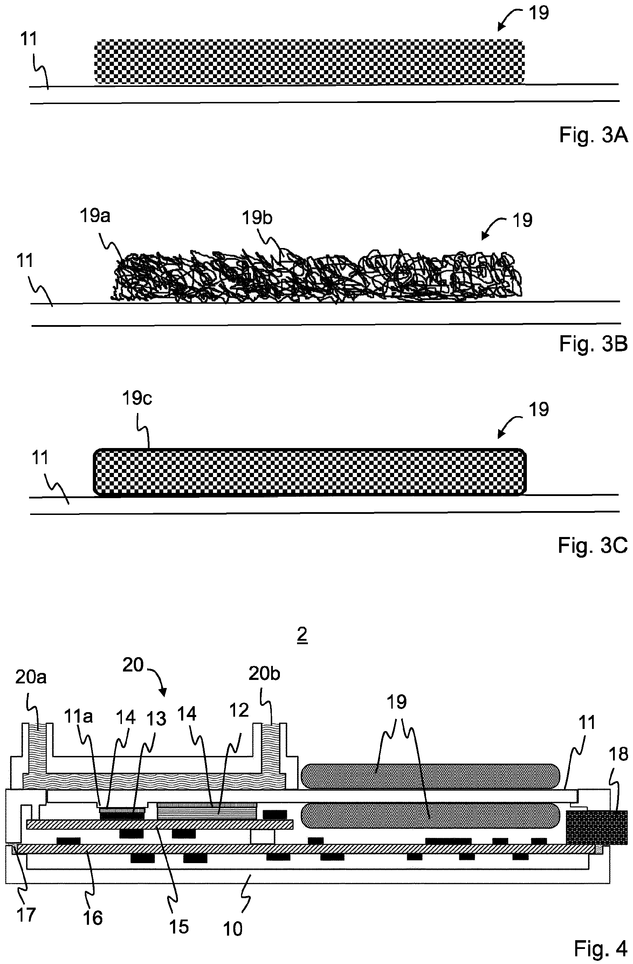

Ferner ist sogenanntes Phasenwechselmaterial 19 bzw. PCM (Phase-Change-Material) aufgebracht bzw. an der Dampfkammer 11 angeordnet, wie in Fig. 3A gezeigt, welches z. B. ein Volumen von 50, 100, 200 ccm bis zu 1000 cm³ und mehr einnehmen kann. Es sollte hierbei ein Material verwendet werden, welches durch Zusatz von z. B. Kunststoff und bevorzugt Blockpolymeren oder anderen Stoffen am Wegfließen beim Überschreiten der Schmelztemperatur (beim herstellerseitigen Anordnen an der Dampfkammer) gehindert wird und welches durch Zusetzen von weiteren thermisch leitfähigen Stoffen, z. B. Graphit oder Kupfergeflecht oder Kupferpartikel oder dergleichen, auch eine noch bessere Wärmeleitfähigkeit erhält, um u.a. ein gleichmäßigeres Aufschmelzen des Phasenwechselmaterials 19 zu begünstigen. Die Dicke des Materials kann dabei einige Millimeter aber auch einige Zentimeter betragen und kann derart aufgebracht sein, dass z. B. höhere Komponenten oder Gehäusebereiche ausgespart werden können (die Figuren sind hierbei nicht ganzheitlich maßstabsgetreu dargestellt). Die Verwendung von Additiven bezüglich der thermischen Leitfähigkeit vermindert die Aufwendung an der Dampfkammer 11. Gegebenenfalls an der Dampfkammer 11 angebrachte bzw. vorgesehene Strukturen, wie Finnen, Pins, Zacken oder Rippen oder dergleichen, erleichtern die Anordnung des Phasenwechselmaterials und verbessern durch bessere thermische Kopplung das Aufschmelzverhalten. Gemäß einer besonderen Ausgestaltung kann auch z. B. gut wärmeleitfähiges Kupfer- oder Aluminiumgeflecht knäul- oder fliesartig an der Dampfkammer 11 angeordnet werden. Das Kupfer- oder Aluminiumgeflecht wird dann mit Phasenwechselmaterial verfüllt, wie in Fig. 3B gezeigt, indem durch das Kupfer- oder Aluminiumgeflecht eine Art Metallgewirk 19a entsteht, in dessen Zwischenräume 19b das Phasenwechselmaterial eingebracht wird. Das Flies- oder Knäulgewirk kann vorzugsweise auch mit Noppen oder Ähnlichem an der Dampfkammer 11 zusammenwirken. Dadurch wird auch die Wärmeleitfähigkeit zum Phasenwechselmaterial hin deutlich verbessert. Das Verdickungsmittel, welches das Wegfließen des Phasenwechselmaterial nach dem Erreichen der Schmelztemperatur verhindert, wird vorzugsweise nur in solchem Maße eingebracht, dass eine Erweichung stattfindet, aber kein Wegfließen im Betrieb der Steuergeräte im Temperaturbereich erfolgen kann. Eine zähe bzw. puddingartige Konsistenz kann hier bevorzugt im heißen Zustand eingestellt werden. Bei der Auswahl des Materials gilt, dass umso weniger "Verdickungsmittel" (z. B. Blockpolymere) eingesetzt wird, umso stärker bleibt die Phasenwechselmaterial-Eigenschaft der hohen Schmelzenergieaufnahme erhalten. Das Fließverhindern der PCM-Mischung erlaubt es, kein abdichtendes Gehäuse um das Wasserwechselmaterial herum vorsehen zu müssen, dennoch kann eine Hülle 19c vorgesehen sein, wie in Fig. 3C gezeigt, welche das Phasenwechselmaterial umschließt. Die Mischung wird dabei vorzugsweise derart eingestellt bzw. gewählt, dass diese bei einer Temperatur, welche über der zulässigen Schmelztemperatur der Mischung (inkl. Blockpolymere) liegt, flüssig ist und somit gut vermischt werden und auch an die Druckkammer 11 (ggf. mit Pins, Finnen und dergleichen) eingefüllt werden kann. Diese (hohe) Temperatur wird dabei im Herstellungsprozess und beim ggf. erforderlichen Recycling des Materials erreicht, nicht aber im Normalbetrieb. Da es sich vorwiegend um eine Mischung und keine Lösung von Stoffen handelt, wird das Verfahren des Einbringens durch Erhitzen und Aufrühren der Mischung wie auch bevorzugt das Einbringen an der vorgeheizten Dampfkammer 11 und deren etwaige Strukturierung bzw. Verrippung (z. B. durch thermische Behandlung und/oder mittels Laser) ausgeführt. Das Befüllen kann vorzugsweise durch ein Eingießen auf den gewünschten vorgeheizten Bereich erfolgen, wobei ein Auslaufen durch am Produkt verbleibende Schottwände oder durch nach dem Erstarren wieder entfernbare Formteile, z. B. aus Silikon oder Teflon, welche bevorzugt wiederverwendbar sind, verhindert werden kann. Hierbei wird der Prozess des Aufheizens wie auch des Abkühlens des Dampfkammer-Rippen/Pin-Gebildes, mittels der Nutzung der Dampfkammer 11 besonders hervorgehoben, da dieser eine schnellere Taktzeit in der Fertigung erlaubt.

In Fig. 4 ist eine Ausgestaltung der Steuereinrichtung 2 gezeigt, bei der eine im Vergleich zur Ausgestaltung nach Fig. 2 kleinere Fluidkühlung 20 vorgesehen ist, wobei die Dampfkammer 11 sozusagen als "Inlay" im Gehäusedeckelteil des Steuereinrichtungsgehäuses 10 vorgesehen ist und an der Dampfkammer 11 beidseitig angebrachte Phasenwechselmaterialien 19 aufweist.

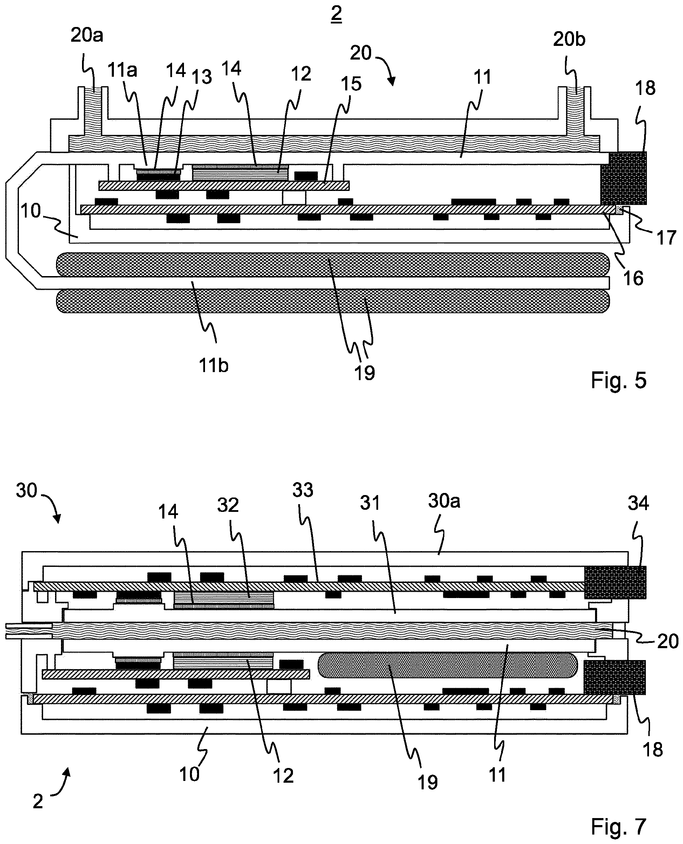

Die in Fig. 5 dargestellte Dampfkammer 11 ist gleichzeitig ein Deckel des Steuereinrichtungsgehäuses 10. Zusätzlich ist die Dampfkammer 11 hierbei derart ausgestaltet, dass diese als Ansatz bzw. Umformung 11b aus dem Steuereinrichtungsgehäuse 10 herausgeführt wird bzw. verlängert wurde, um an einen externen angeordnetes Phasenwechselmaterial 19 herangeführt zu werden. Alternativ oder zusätzlich kann eine beidseitige Anbindung des Phasenwechselmaterials 19 über Rippen, Finnen oder Pins oder dergleichen erfolgen, die an der Verlängerung bzw. der Umformung 11b angeordnet sein können. Die Positionierung des Phasenwechselmaterials 19 muss bei derartigen Ausgestaltungen nicht zwangsläufig parallel zum Steuereinrichtungsgehäuse 10 erfolgen, sondern kann auch in einer anderen Art und Weise angeordnet sein (in den Figuren nicht dargestellt). Zudem kann die Umformung11b in jeglicher Form aus dem Steuereinrichtungsgehäuse 10 herausragen oder in diesem untergebracht sein.

Ferner kann die Dampfkammer 11 als Strangpressprofil oder Fließpressteil und/oder Stanzteil(en) und/oder dergleichen hergestellt sein und/oder auf der Außenseite bzw. außen (außerhalb der Kammerbereiches) Rippen oder Pins oder Finnen aufweisen, welche im Prozess der Deckelherstellung (Strangpressprofil mit Rippen, oder Finnen oder Pins per Fließpressprozess) erzeugt werden können oder nachträglich aufgebracht (z. B. via Laser erzeugt oder aufgelötet oder dergleichen) werden, welche eine gute thermische Verbindung mit dem Phasenwechselmaterials bilden bzw. eine gute thermische Anbindung gewährleisten.

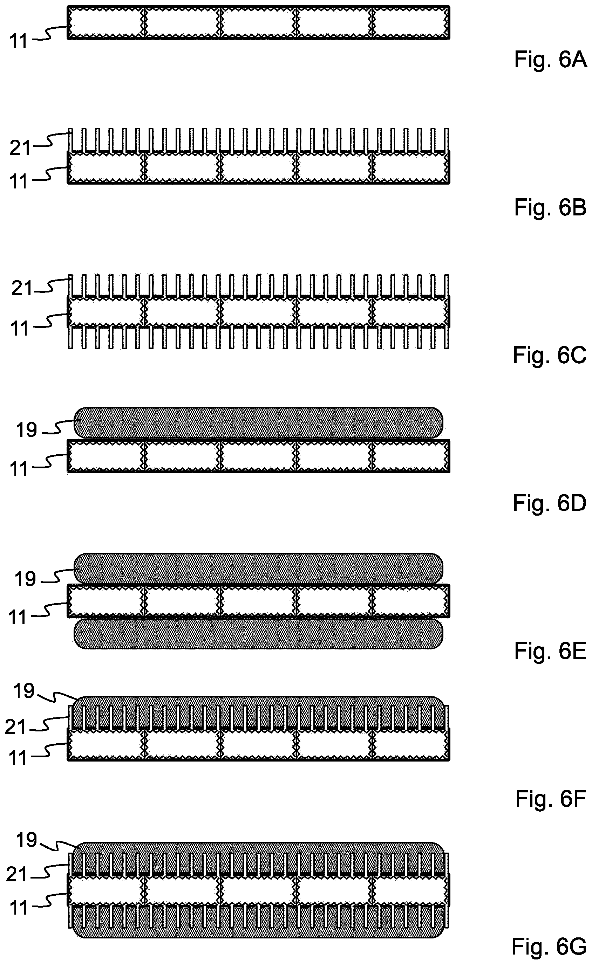

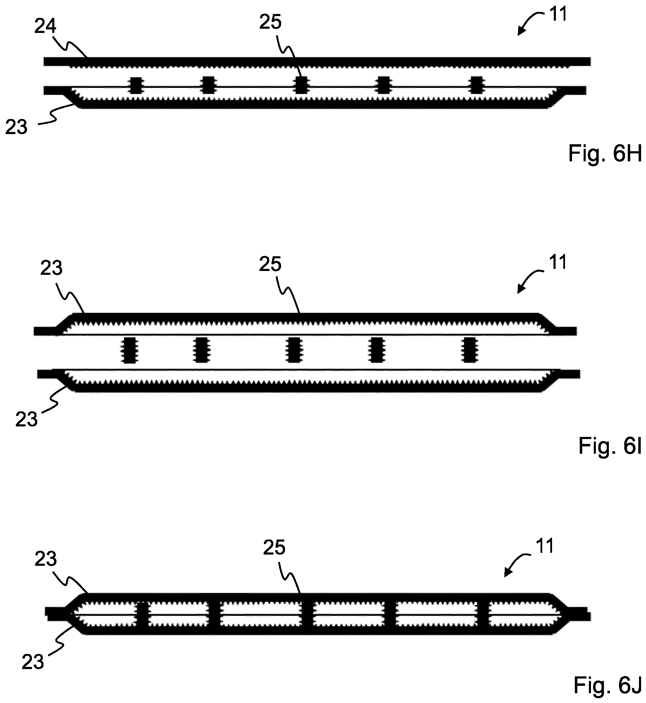

In Fig. 6A-6J sind unterschiedliche Ausgestaltungsvarianten der Dampfkammer 11 sowie dazugehörigen Phasenwechselmaterials 19 dargestellt. Die Dampfkammer 11 ist hierbei im Schnitt gezeigt, wobei die inneren Kanäle der Dampfkammer 11 sowie eine innenliegende Kapillarstruktur (dargestellt durch randseitige Zacken) sichtbar sind. Fig. 6A zeigt hierbei eine Ausgestaltung der Dampfkammer 11, die weder Kühlstrukturen auf der Oberfläche noch Phasenwechselmaterial 19 aufweist Fig. 6B zeigt eine Ausgestaltung der Dampfkammer, die an einer Seite Rippen 21 aufweist, während die Dampfkammer 11 in Fig. 6C an beiden Seiten Rippen 21 aufweist. In Fig. 6D ist eine Ausgestaltung der Dampfkammer es gezeigt, bei der an einer Seite ein Phasenwechselmaterial 19 angeordnet ist, während in Fig. 6D das Phasenwechselmaterial 19 beidseitig angeordnet ist. Die Fig. 6F und 6G zeigen dabei Ausgestaltung der Dampfkammer 11, bei der entweder einseitig (Fig. 6F) oder beidseitig (Fig. 6G) Rippen 21 angeordnet sind und zugleich Phasenwechselmaterial 19 angeordnet ist, in welches sich die Rippen 21 erstrecken bzw. in welches die Rippen 21 eingreifen. Anstelle von Rippen 21 können in allen Ausgestaltungen auch Finnen, Pins, Zacken, Pyramidenstrukturen oder dergleichen als Strukturen vorgesehen sein, die einen verbesserten Wärmeübertrag von der Dampfkammer 11 auf das Phasenwechselmaterial 19 ermöglichen sollen, sodass dieses schneller und gleichmäßiger aufschmilzt, so dass das Phasenwechselmaterial 19 auch in größerem Umfang bzw. dicker ausgeführt sein kann, wodurch die Überbrückungszeit verlängert werden kann. Sofern derartige Strukturen nicht vorgesehen werden, kann das Phasenwechselmaterial 19 auch ohne diese aber dann ggf. dünner aufgetragen werden oder ggf. über ein Gewirk bzw. Metallgewirk 19a angeordnet werden. Gemäß einer Ausgestaltungsvariante der Dampfkammer 11 kann diese ein Aluminiumgehäuse umfassen, welches vorzugsweise in unmittelbaren Kontakt zum Wasserstrom steht. Sofern eine Kupfer-Dampfkammer in einem Aluminium basierenden Kühlkreislauf eingesetzt wird, kann als Trennmedium zwischen einer aufgesetzten Wasserkühleinheit inklusive dem Fluid der Fluidkühlung optional eine Folie oder eine Beschichtung hin zur Dampfkammer und oder Gehäuseteilen eingebracht sein, welche optional auch eine Dichtwirkung des zusammengesetzten Teiles bewirkt, um eine chemische (galvanische) Trennung zum Fluidmedium sicherzustellen. Ferner zeigt Fig. 6H eine Ausgestaltung einer mehrteiligen Dampfkammer 11 vor dem Zusammenbau, die zwei größere Teile (Boden 23 und Deckel 24) sowie dazwischen befindliche Stützen 25 umfasst, welche dann durch den Zusammenbau innere Wandungen erzeugen, indem die einzelnen Teile z. B. mittels Löten oder Schweißen zusammengefügt werden (z. B. zusammengesetzte Stanzteile). Der Boden 23, der Deckel 24 und die Stützen 25 weisen hierbei ebenfalls eine Kapillarstruktur auf (Zackung an der Innenwand - die Kapillarstruktur könnte aber auch durch eine andere Ausgestaltung realisiert sein). Ferner zeigt Fig. 6l eine Ausgestaltung der Dampfkammer 11 vor dem Zusammenbau, bei der zwei wannenartige Böden 23 die Dampfkammer 11 bilden. Fig. 6J zeigt die Dampfkammer 11 aus Fig. 6l im zusammengesetzten Zustand. Auch die mehrteiligen Dampfkammern gemäß Fig. 6H-6J können selbstverständlich Kühlstrukturen auf der Außenseite umfassen, die in den Figuren nicht explizit dargestellt sind.

Ausdrücklich wird hierbei erwähnt, dass auch alle Ausgestaltungen des Phasenwechselmaterials 19 in den Figuren, die ohne Strukturen, Gewirke oder Hülle dargestellt sind, diese ebenfalls aufweisen könnten. Ferner kann die Dampfkammer 11 auch aus Kupfer sein, welche in Kombination mit dem flexiblen Kühlpad eine elektrochemische Trennung der Kühlflüssigkeit und der Kupfer-Dampfkammer bereitstellt (wobei hinsichtlich der Kühlung Kupfer in der Regel geringfügig bessere Eigenschaften aufweist als Aluminium).

Gemäß einer vorteilhaften Ausgestaltung kann mindestens ein elastischer Balg oder Kühlpad als Kühlvorrichtung vorgesehen sein (in Fig. 2-4 nicht gezeigt), der/das zumindest teilweise aus flexiblem Material gefertigt ist, so dass sich der elastische Balg bzw. das flexible Kühlpad an die Dampfkammer und ggf. auch an das Gehäuse anschmiegt. Durch das Kühlpad können somit toleranztechnisch bedingte, leicht unterschiedliche Lageausrichtungen von thermischen Komponenten und/oder Gehäuse ausgeglichen werden. Insbesondere kann es sich hierbei um ein Kühlpad handeln, wie bereits in DE 10 2021 209 640 A1 beschrieben wird.

Aufgrund der flexiblen Eigenschaft des Materials schmiegt sich dieses an die umgebenden Komponenten wie die Dampfkammer 11 insbesondere beim Ausdehnen an (z. B. wenn dieses dann mit Fluid gefüllt wird). Zweckmäßigerweise kann als flexibles Material Metallfolie, insbesondere Aluminiumfolie oder Kupferfolie, und/oder Kunststofffolie und/oder ein Laminat und/oder eine Verbundfolie, welche insbesondere eine Metallfolie und mindestens eine Kunststofffolie umfasst, vorgesehen sein, da derartige Folien in einfacher Weise und kostengünstig herstellbar und verarbeitbar sind. Dadurch, dass als flexibles Material eine Verbundfolie oder ein Laminat vorgesehen ist, kann die Haltbarkeit und Stabilität der Kühlanordnung in einfacher Weise verbessert werden. Ferner kann das flexible Material auch eine Beschichtung aufweisen, insbesondere eine Aluminiumbeschichtung, um die Eigenschaften hinsichtlich Stabilität, Dichtigkeit, Alterung, Haltbarkeit zu verbessern. Insbesondere eignen sich auch Anoxal-Schichten (Anoxal-Verfahren = durch anodische Polarisierung des Aluminiums entsteht eine Aluminiumoxidschicht auf der Oberfläche des Aluminiums) oder Eloxal-Schichten (Eloxal-Verfahren = elektrolytische Oxidation von Aluminium, wobei eine oxidische Schutzschicht auf Aluminium durch anodische Oxidation erzeugt wird) als Beschichtung einer Aluminiumfolie. Ferner kann das Kühlpad mit einem Kühlmedium gefüllt sein oder mit einem Kühlmedium durchströmt werden, wobei als Kühlmedium ein Fluid, insbesondere Wasser, Glykol, ein Wasser-Glykolgemisch, Luft, CO2 oder dergleichen, vorgesehen ist.

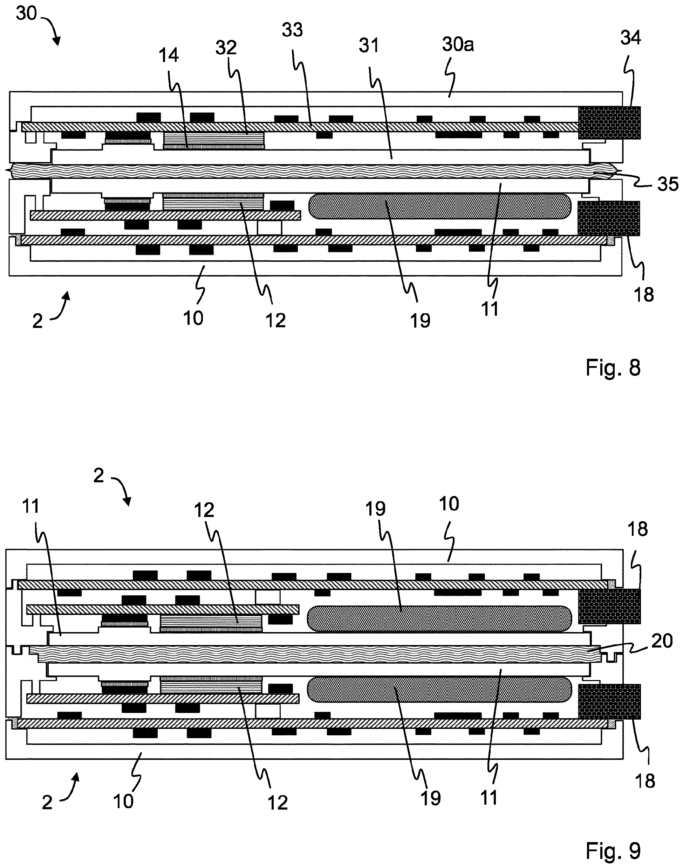

Fig. 7 zeigt eine Ausgestaltung eines erfindungsgemäßen Steuereinrichtungssystems, bei dem ein Stack umfassend zwei Steuergeräte bzw. Steuereinrichtungen 2, 30 mit dazwischenliegender Flüssigkeitskühlung 20 bzw. Wasserkühlung und eingeklebten oder eingeschweißten Dampfkammern 11, 31. Die Steuereinrichtung 30, weist hierbei ein Steuereinrichtungsgehäuse 30a, eine Dampfkammer 31, eine zu kühlende Komponente 32 auf einer Leiterplatte 33, ein Anschlussstück 34 auf. Darüber hinaus können auch alle weiteren Komponenten Teil der Steuereinrichtung 30 sein (die der Übersichtlichkeit halber jedoch nicht näher beschrieben sind). Ferner weist die Steuereinrichtung 2 ein Phasenwechselmaterial 19 auf, welches an der Dampfkammer 11 angeordnet ist. Der Kühlmittelfluss sollte beim Erreichen der Maximaltemperatur im Fehlerfall des Kühlsystems abgeschaltet werden, so dass die Kühlung dann wirksam über das Phasenwechselmaterial 19 erfolgen kann. Ferner sollte hierbei die Steuereinrichtung 30, die nicht durch ein Phasenwechselmaterial gekühlt wird, im Fehlerfall insbesondere kontrolliert abgeschaltet und/oder heruntergefahren werden. Fig. 8 zeigt eine ähnliche Ausgestaltung wie Fig. 7, wobei als Kühlvorrichtung ein flexibles Kühlpad 35 vorgesehen ist, dass zwischen den Dampfkammern 11, 31 angeordnet ist und somit Wärme vom beiden Dampfkammern 11, 31 abführen kann. Darüber hinaus zeigt Fig. 9 eine Ausgestaltung eines erfindungsgemäßen Steuereinrichtungssystems, bei dem zwei gleichartig Steuereinrichtungen 2 aneinander angeordnet sind, derart, dass dazwischen ein Fluidkühlsystem 20 angeordnet ist, welches beidseitig von den Dampfkammern 11 begrenzt wird. Die Dampfkammern 11sind hierbei als Deckel des jeweiligen Steuereinrichtungsgehäuses 10 ausgestaltet und gleichzeitig integraler Bestandteil des jeweiligen Steuereinrichtungsgehäuses 10. Ferner sind die Steuereinrichtungsgehäuse 10 ineinandergesteckt und insbesondere miteinander verklebt oder verschweißt, sodass das Steuereinrichtungssystem eine nicht ohne weiteres lösbare Einheit bildet.

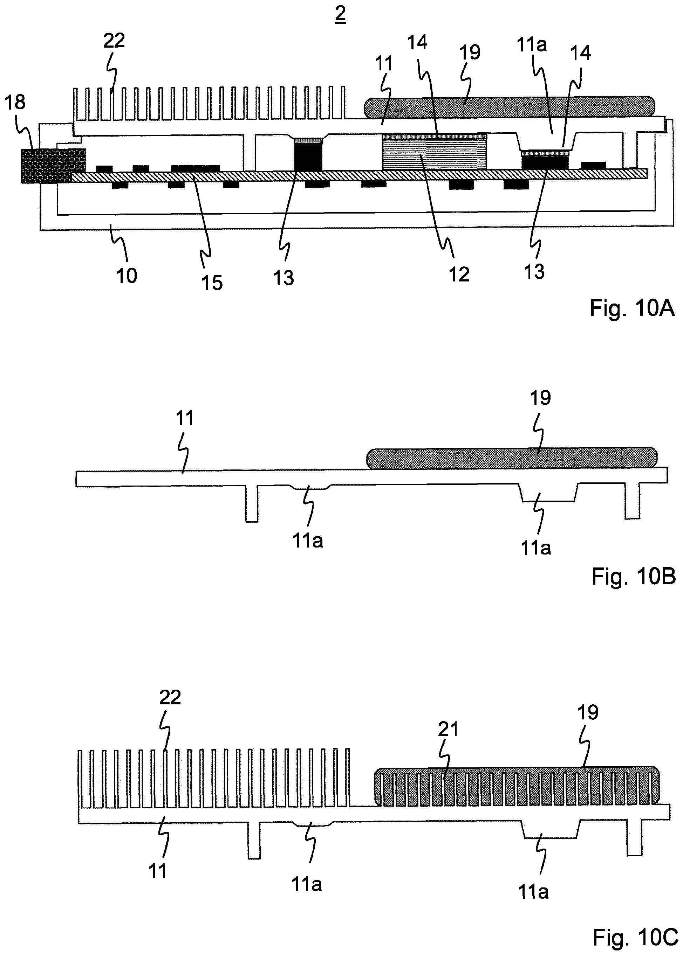

Ferner zeigt Fig. 10A eine Ausgestaltung der erfindungsgemäßen Steuereinrichtung 2, bei der die Dampfkammer 11 Phasenwechselmaterial 19 aufweist, welches an der Dampfkammer 11 angeordnet ist. Die Dampfkammer 11 bildet dabei den Deckel des Steuereinrichtungsgehäuses 10. Ferner sind Kühlrippen 22 als Kühlvorrichtung (bzw. auch Teil der Kühlvorrichtung, wenn diese zusammen mit einem Lüfter ausgestaltet ist) vorgesehen, die z. B. während der Herstellung der Dampfkammer 11 erzeugt werden können (z. B. mittels Laser, aufgelötet, angeschweißt oder dergleichen). In Fig. 10B ist eine weitere Ausgestaltung der Dampfkammer 11 gezeigt, die in der Steuereinrichtung 2 nach Fig. 9A eingesetzt werden kann und keine außenseitigen Kühlrippen aufweist. Darüber hinaus zeigt Fig. 10C eine weitere Ausgestaltung der Dampfkammer 11, bei der außenseitige Kühlrippen 22 und zusätzlich außenseitige Rippen 21, die zusammen mit dem Phasenwechselmaterial 19 ineinandergreifen, wobei sich das Phasenwechselmaterial 19 bei der Herstellung aufgrund seiner Materialeigenschaften an die Rippen 21 anschmiegt, da dieses zunächst auf eine Temperatur erhitzt wird, die über der "normalen" Betriebstemperatur liegt, so dass das Phasenwechselmaterial 19 um die Rippen 21 herum fließen kann und nach dem anschließenden Festigen um diese herum verteilt ist, so dass die Rippen 21 in das Phasenwechselmaterial 19 hineinragen bzw. eingreifen. Durch die Rippen 21 wird die Wärme in das Phasenwechselmaterial 19 eingetragen, so dass dieses dann gleichmäßig aufschmelzen kann, wodurch die Wärmeaufnahme bzw. der Wärmeabtrag in besonderem Maße verbessert wird. Die Steuereinrichtung 2 nach Fig. 10A weist somit keine Flüssigkeitskühlung auf (d. h. verminderte Verlustleistung), wobei z. B. eine Lüfterkühlung (Lüfter nicht dargestellt) vorgesehen sein kann, womit sich bei Ausfall der Kühlwirkung durch hinreichende Belüftung über das Phasenwechselmaterial dennoch eine Nachlaufzeit bzw. Überbrückungszeit ohne Überhitzung darstellen lässt.

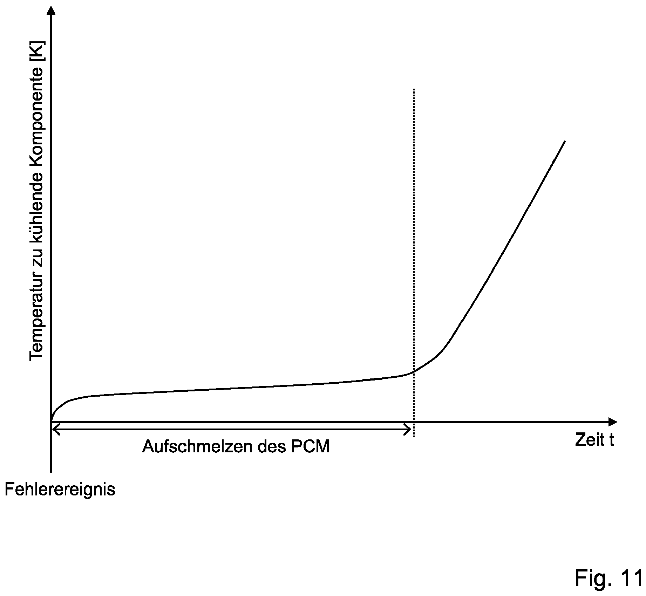

In Fig. 11 ist der Zusammenhang zwischen der Temperatur an der zu kühlenden Komponente und dem Aufschmelzen des Phasenwechselmaterials nach dem Eintreten eines Fehlerereignisses und z. B. dem damit einhergehenden Ausfall eines Kühlsystems gezeigt, der in der Regel bei den erfindungsgemäßen Realisierungen/Ausgestaltungsvarianten auftritt. Hierbei ist gut zu erkennen, dass die Temperatur der zu kühlenden Komponente auch nach dem Ausfall für mehrere Minuten durch das Aufschmelzen des Phasenwechselmaterials 19 und der damit einhergehenden Wärmeaufnahme nahezu konstant gehalten werden kann.

Selbstverständlich kann die erfindungsgemäße Kühlanordnung auch zum Erwärmen einer zu erwärmenden Komponente eingesetzt werden (sozusagen als Heizvorrichtung), indem diese mit einem Medium befüllt wird, welche Wärme an eine zu erwärmende Komponente abgibt. Hierzu kann die Kühlvorrichtung in einfacher Weise über die Anschlüsse an einen Heizkreislauf angeschlossen werden, um mit Heizmedium versorgt zu werden, welches dann die Kühlanordnung bzw. Heizvorrichtung durchströmt. Beispielsweise könnte das erfindungsgemäße Rack bzw. die erfindungsgemäße Kühlanordnung auch zum Erwärmen einer oder mehrerer Baugruppen, insbesondere im Bereich Automotive, eingesetzt werden.

### Bezugszeichenliste

- 1: Fahrzeug
- 2: Steuereinrichtung
- 3: Lenkung
- 4: Motor
- 5: Bremse
- 6: Radarsensor
- 7: Lidarsensor
- 8: Frontkamera
- 9a-9d: Ultraschallsensor
- 10: Steuereinrichtungsgehäuse
- 11: Dampfkammer
- 11a: Vorsprung
- 11b: Umformung
- 12: Prozessor
- 13: IC-Baustein
- 14: TIM
- 15: Leiterplatte
- 16: Leiterplatte
- 17: Dichtkleber
- 18: Anschlussstecker
- 19: Phasenwechselmaterial
- 19a: Metallgewirk
- 19b: Zwischenraum
- 19c: Hülle
- 20: Fluidkühlung
- 20a: Eingang
- 20b: Ausgang
- 21: Rippe
- 22: Kühlrippe
- 23: Boden
- 24: Deckel
- 25: Stütze
- 30: Steuereinrichtung
- 30a: Steuereinrichtungsgehäuse
- 31: Dampfkammer
- 32: Prozessor
- 33: Leiterplatte
- 34: Anschlussstecker
- 35: Kühlpad

## Patentansprüche

1. Kühlanordnung, umfassend
mindestens eine zu kühlende Komponente, insbesondere angeordnet auf einem Schaltungsträger,
eine Dampfkammer (11, 31), die an der zu kühlenden Komponente angeordnet ist, derart, dass diese mit der zu kühlenden Komponente thermisch leitfähig gekoppelt ist,
eine Kühlvorrichtung, die an der Dampfkammer (11, 31) angeordnet ist, derart, dass die Kühlvorrichtung mit der Dampfkammer (11, 31) thermisch leitfähig gekoppelt ist, und
ein Phasenwechselmaterial (19), das an der Dampfkammer (11, 31) angeordnet ist, derart, dass das Phasenwechselmaterial (19) mit der Dampfkammer (11, 31) thermisch leitfähig gekoppelt ist.

2. Kühlanordnung nach Anspruch 1, **dadurch gekennzeichnet, dass** die Dampfkammer (11, 31) eine im Inneren angeordnete Kapillarstruktur umfasst.

3. Kühlanordnung nach Anspruch 1 oder 2, **dadurch gekennzeichnet, dass** als Kühlvorrichtung eine Fluidkühlung, insbesondere eine Luftkühlung oder eine Flüssigkeitskühlung (20), vorgesehen ist.

4. Kühlanordnung nach einem der vorhergehenden Ansprüche, **dadurch gekennzeichnet, dass** als Kühlvorrichtung ein elastischer Balg oder ein Kühlpad (35) vorgesehen ist, der/das zumindest teilweise aus flexiblem Material gefertigt ist, und derart angeordnet wird, dass sich der elastische Balg oder das Kühlpad (35) an die Dampfkammer (11, 31) anschmiegt, wobei als flexibles Material vorzugsweise Metallfolie, insbesondere Aluminiumfolie oder Kupferfolie, und/oder Kunststofffolie und/oder ein Laminat und/oder eine Verbundfolie, welche insbesondere eine Metallfolie und eine Kunststofffolie umfasst, vorgesehen ist.

5. Kühlanordnung nach einem der vorhergehenden Ansprüche, **dadurch gekennzeichnet, dass** ein Gehäuse vorgesehen ist, insbesondere ein Steuereinrichtungsgehäuse (10, 30a) oder Sensorgehäuse, in welchem die zu kühlende Komponente angeordnet ist.

6. Kühlanordnung nach Anspruch 5, **dadurch gekennzeichnet,**
**dass** die Dampfkammer (11, 31) und/oder die Kühlvorrichtung zumindest teilweise integraler Bestandteil des Gehäuses ist.

7. Kühlanordnung nach einem der vorhergehenden Ansprüche, **dadurch gekennzeichnet, dass** die erste Dampfkammer (11,31) Strukturen, insbesondere Rippen (21) und/oder Noppen und/oder Pins und/oder Finnen, aufweist, zwischen denen das Phasenwechselmaterial (19) angeordnet wird.

8. Kühlanordnung nach einem der vorhergehenden Ansprüche, **dadurch gekennzeichnet, dass** das Phasenwechselmaterial (19) ein Verdickungsmittel, insbesondere einen Fließverhinderer in Form von Blockpolymeren, umfasst.

9. Kühlanordnung nach einem der vorhergehenden Ansprüche, **dadurch gekennzeichnet, dass** das Phasenwechselmaterial (19) an der Dampfkammer (11, 31) angeordnet wird, indem ein Gewirk, insbesondere Metallgewirk (19a) umfassend ein Kupfer- und/oder Aluminiumgeflecht, auf/an der Dampfkammer (11, 31) angeordnet und/oder befestigt ist, dessen Zwischenräume (19b) mit Phasenwechselmaterial verfüllt sind.

10. Kühlanordnung nach einem der vorhergehenden Ansprüche, **dadurch gekennzeichnet, dass** das Phasenwechselmaterial (19) eine Hülle (19c) aufweist, in der das Phasenwechselmaterial (19) angeordnet ist und welche an der Dampfkammer (11, 31) angeordnet ist.

11. Kühlanordnung nach einem der vorhergehenden Ansprüche, **dadurch gekennzeichnet, dass** zwischen der Dampfkammer (11, 31) und der zu kühlenden Komponente ein TIM (14) angeordnet ist.

12. Kühlanordnung nach einem der vorhergehenden Ansprüche, d**adurch gekennzeichnet, dass** die Dampfkammer (11, 31) und die Kühlvorrichtung einstückig ausgestaltet sind, so dass ein Bauteil beide Komponenten umfasst.

13. Kühlanordnung nach einem der vorhergehenden Ansprüche, **dadurch gekennzeichnet, dass** die Dampfkammer (11) eine, insbesondere geschwungene oder U-förmig oder L-förmig gebogene, Umformung (11b) aufweist, welche aus der Dimension des Gehäuses ragt, wobei an der Umformung (11b) zumindest ein Phasenwechselmaterial (19) angeordnet ist.

14. Steuereinrichtung (2) oder Sensor umfassend eine Kühlanordnung nach einem der vorhergehenden Ansprüche.

15. Steuereinrichtungssystem, umfassend mindestens eine Kühlanordnung nach einem der Ansprüche 1-13 oder mindestens eine Steuereinrichtung (2) nach Anspruch 14, umfassend
mindestens zwei Steuereinrichtungen (2, 30), jeweils umfassend mindestens eine zu kühlende Komponente und eine Dampfkammer (11, 31), die an der zu kühlenden Komponente angeordnet ist, derart, dass diese mit der zu kühlenden Komponente thermisch leitfähig gekoppelt ist, und eine Kühlvorrichtung, die an den Dampfkammern (11, 31) der Steuereinrichtungen (2, 30) angeordnet ist, derart dass die Kühlvorrichtung mit den Dampfkammern (11, 31) der Steuereinrichtungen (2, 30) thermisch leitfähig gekoppelt ist.

16. Steuereinrichtungssystem nach Anspruch 15, **dadurch gekennzeichnet, dass** die Steuereinrichtungen (2, 30) jeweils ein Steuereinrichtungsgehäuse (10, 30a) aufweisen und die
Steuereinrichtungsgehäuse (10, 30a) miteinander mechanisch verbunden sind, insbesondere verklebt, verschweißt, verschraubt, vernietet oder dergleichen.
